# EUROPEAN PATENT SPECIFICATION

(11) **EP 0 447 085 B1**
(45) Date of publication and mention of the grant of the patent: **10.09.1997**
(21) Application number: 91301765.3
(22) Date of filing: 04.03.1991
(51) Int. Cl.: H01L 21/607, B65H 59/00

(54) **Device for monotoring wire supply and consumption**
Vorrichtung zur Überprüfung von Drahtzufuhr und -verbrauch
Dispositif pour l'affichage de l'alimentation en fil métallique et de sa consommation

(30) Priority: 16.03.1990 GB 9006000
(43) Date of publication of application: 18.09.1991
(73) Proprietor: F & K Delvotec Bondtechnik GmbH, D-82041 Oberhaching (DE)
(72) Inventor: Farassat, Farhad, W-8028 Taufkirchen (DE)
(74) Representative: MEISSNER, BOLTE & PARTNER

(56) References cited:
- US-A- 3 485 426
- US-A- 3 587 959
- US-A- 4 572 421
- US-A- 4 763 826
- PATENT ABSTRACTS OF JAPAN, unexamined applications, E section, vol. 13, no. 74, 20 February, 1989 THE PATENT OFFICE JAPANESE GOVERNMENT page 112 E 717; & JP-A-63-257 238

## Description

The present invention relates to a device for incorporation in an apparatus for automatic wire bonding, in particular for wedge bonding using thick wire having a diameter of at least 4 mil [1 mil=2.54.10⁻³ cm], which device makes it possible to monitor the amount of wire consumed during wire bonding, and to monitor the wire for breakages or feeding failures.

Wire bonding is the process of making electrical connections in semiconductor components by means of metal wire. Examples of electrical connections which can be made using wire bonding techniques include connections between the contact surfaces of discrete or integrated chips and the contact leads of their packages, and, in the case of hybrid circuits, the connections between inserted monolithic elements and the film circuit which contains them.

A number of wire bonding techniques have been developed, and one which has been particularly successful is a microwelding technique using ultrasound. An automatic wire bonding apparatus on which such a technique can be operated is described in German Patent Application, DE-A-3343738. Aluminium wire, in contact with the contact surface to which it is to be bonded, is moved vigorously in the direction of the surface to which it is to be bonded so that its oxide layer breaks open. The wire is then subjected to pressure, and a permanent junction is created between the two materials. Motion of the wire is generated by an ultrasonic transducer excited by an ultrasonic generator to produce high-frequency mechanical vibrations.

In the particular wire bonding process known as wedge bonding, the ultrasonic energy is supplied in the range of 1 to 50 watts, depending on the wire size used. The ultrasonic energy is directed to the aluminium wire by a special tool known as a "wedge". The wire is fed through a hole at the bottom of the wedge. When the wedge with the aluminium wire touches the surface to which the wire is to be bonded, movement is stopped. The wire is pressed down with a small defined force, known as the bonding weight, and the wire is slightly deformed. This small deformation is known as the "pre-deformation". Ultrasonic energy is now switched on, and the welding process starts. During this time, the diameter of the aluminium wire is reduced by a few microns, the actual reduction depending on the size, physical properties and the precise chemical nature of the wire.

In known wire bonding apparatus, the wire is fed directly from a wire feed spool to the bonding wedge and the amount of wire consumed during a bonding operation is not monitored.

It is important, particularly in an automatic wire bonding apparatus, for the operator to have as much control over the process as possible. In order to achieve this, it is important for the operator to have as much information as possible on the progress of the bonding operation. In this connection, it would be helpful to the operator to be able to monitor the amount of wire consumed, and also to monitor the wire to ensure that if the wire breaks or the feed jams, this can be remedied as soon as possible.

It is a disadvantage of known wire bonding apparatus that there is no provision in such apparatus for monitoring the amount of wire consumed, or whether there is any breakage or feeding difficulty with the wire. Further wire bonding apparatus are disclosed in US-A-4572421, US-A-4763826 and US-A-3485426.

It is an object of the present invention to provide a device for incorporation in an apparatus for wire bonding, in which the above disadvantages are reduced or substantially obviated.

The present invention as claimed in claim 1 provides a device for incorporation in a wire bonding machine, for monitoring the supply of wire from a wire supply spool to a bonding wedge, which device comprises
a mount for rotatably mounting a wire supply spool;
a guide wheel mounted on a lever, which lever can be deflected between a first position to which it is biassed by a spring and a second position at which it activates a sensor;
a motor for driving the wire supply spool, which motor is started by the sensor when the sensor is activated by the lever
and means for stopping the motor when a predetermined amount of wire has been supplied,
and wherein the wire passes over the wheel between the wire supply spool and the bonding wedge, so that the consumption of wire during a bonding cycle causes deflection of the lever from its first position to its second position, the means for stopping the motor when a predetermined amount of wire has been supplied comprises a second sensor, located so that it is activated by the spring-loaded lever in a third position of that lever, on the opposite side of the first position to that of the second position. The second sensor is preferably adjustable, to allow for the supply of different amounts of wire.

In an alternative embodiment of the device according to the invention, where the amount of wire being used is relatively long, the means for stopping the motor when a predetermined amount of wire has been supplied comprises a timer switch, which switches off the motor after a predetermined time.

The sensor or sensors provided in the device according to the invention may be any suitable type of sensors, for example magnetic sensors or light barriers: light barriers are particularly preferred. The sensor or sensors are preferably also connected to the control system for the bonding machine, to ensure that the bonding operation is only carried out when the correct amount of wire is being supplied, and there is no breakage in the wire.

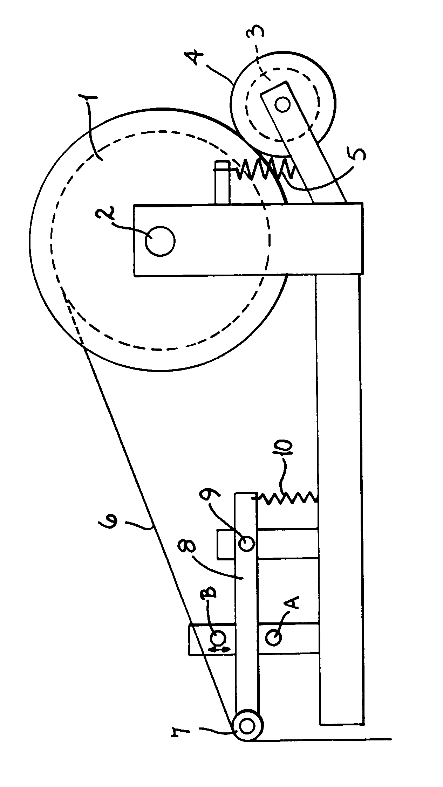

An embodiment of the device according to the invention will now be described with reference to the accompanying drawing, which shows a sectional view of the device.

A wire supply spool (1) is mounted for rotation about a pivot (2). A motor (3) is mounted adjacent to the spool (1) and has a rubber wheel (4) which is biassed by a spring (5) into engagement with the spool (1). A wire (6) is fed from the spool (1) over a grooved guide wheel (7) to the bonding wedge of a wire bonder (not shown). The guide wheel (7) is preferably made of a plastics material and is mounted for free rotation about a bearing on the end of a lever (8) which is mounted on a pivot (9) and biassed by a spring (10). The lever (8) can be deflected about the pivot (9) between a first sensor (A) and a second, adjustable sensor (B).

In operation, as the wire (6) is consumed during a bonding cycle, the guide wheel (7) is pulled down so that the lever (8) activates the sensor (A), which is preferably a light barrier. The sensor (A) sends a signal to start the motor (3) which is engaged with the spool (1). The motor (3) is started and turns the spool (1) so that wire (6) is supplied, until the lever (8) reaches the sensor (B) and the motor (3) is stopped.

The position of the sensor (B) can be adjusted as shown by the double-headed arrow to allow for the supply of different amounts of wire.

The spring loading of the rubber wheel (4) allows for slight variations in the dimensions of the wire supply spool (1).

The device according to the invention can be used to monitor the amount of wire consumed during a bonding cycle, to determine and indicate any breakages in the wire, and to identify any failures in the supply of wire from the spool.

The device according to the invention is particularly suitable for monitoring the supply and consumption of relatively thick bonding wire, in particular wire having a diameter of at least 4 mil, more particularly wire having a diameter of from 4 to 20 mil.

## Claims

1. A device for incorporation in a wire bonding machine, for monitoring the supply of wire from a wire supply spool to a bonding wedge, which device comprises:
a mount (2) for rotatably mounting a wire supply spool (1);
a guide wheel (7) mounted on a lever (8), which lever (8) can be deflected between a first position to which it is biased by a spring (10) and a second position at which it activates a first sensor (A);
a motor (3) for directly driving the wire supply spool (1), which motor (3) is started by the first sensor (A) when the sensor is activated by the lever (8);
a second sensor (B), located to be activated by the lever (8), for stopping the motor when a predetermined amount of wire has been supplied, said lever then being in a third position, on the opposite side of the first position to that of the second position;
wherein the wire (6) passes over the guide wheel (7) between the wire supply spool (1) and the bonding wedge so that the consumption of wire during a bonding cycle causes deflection of the lever (8) from its first position to its second position; and
wherein the position of the second sensor (B) can be adjusted to allow for the supply of different amounts of wire.

2. A device according to Claim 1, wherein the second sensor for stopping the motor (3) comprises a time switch.

3. A device according to Claim 1 or 2, wherein the first sensor (A) and/or the second sensor (B) is a light barrier.

## Patentansprüche

1. Vorrichtung zum Einbau in eine Drahtbondmaschine, um die Drahtzuführung von einer Drahtvorlagespule zu einem Bondkeil zu überwachen, wobei die Vorrichtung folgendes aufweist:
ein Gestell (2), um eine Drahtvorlagespule (1) drehbar anzubringen;
ein Führungsrad (7), das an einem Hebel (8) angebracht ist, wobei der Hebel (8) zwischen einer ersten Position, in die er von einer Feder (10) vorgespannt wird, und einer zweiten Position, in der er einen ersten Sensor (A) aktiviert, auslenkbar ist;
einen Motor (3), um die Drahtvorlagespule (1) direkt anzutreiben, wobei der Motor (3) von dem ersten Sensor (A) gestartet wird, wenn der Sensor von dem Hebel (8) aktiviert ist;
einen zweiten Sensor (B), der so positioniert ist, daß er von dem Hebel (8) aktiviert wird, um den Motor anzuhalten, wenn eine vorbestimmte Drahtmenge vorgelegt worden ist, wobei der Hebel dann in einer dritten Position auf der entgegengesetzten Seite der ersten Position zu derjenigen der zweiten Position ist;
wobei der Draht (6) über das Führungsrad (7) zwischen der Drahtvorlagespule (1) und dem Bondkeil so verläuft, daß der Verbrauch von Draht während eines Bondzyklus eine Auslenkung des Hebels (8) aus seiner ersten Position in seine zweite Position bewirkt; und
wobei die Position des zweiten Sensors (B) verstellt werden kann, um die Vorlage unterschiedlicher Drahtmengen zu gestatten.

2. Vorrichtung nach Anspruch 1, wobei der zweite Sensor zum Anhalten des Motors (3) einen Zeitschalter aufweist.

3. Vorrichtung nach Anspruch 1 oder 2, wobei der erste Sensor (A) und/oder der zweite Sensor (B) eine Lichtschranke ist.

## Revendications

1. Dispositif destiné à être incorporé dans une machine de connexion de fils pour surveiller l'alimentation en fil depuis une bobine d'alimentation en fil à un poinçon de connexion, ce dispositif comprenant :
une monture (2) qui supporte, libre en rotation, une bobine d'alimentation en fil (1) ;
une roue de guidage (7) montée sur un levier (8), ce levier (8) pouvant être défléchi entre une première position dans laquelle il est poussé par un ressort (10) et une deuxième position dans laquelle il active un premier capteur (A) ;
un moteur (3) pour entraîner directement la bobine d'alimentation en fil (1), ce moteur (3) étant démarré par le premier capteur (A) quand le capteur est activé par le levier (8) ;
un deuxième capteur (B), placé de façon à être activé par le levier (8) pour arrêter le moteur quand l'alimentation en fil correspond à une quantité prédéterminée, ce levier se trouvant alors dans une troisième position, du côté opposé à la première position par rapport à la deuxième position ;
dans laquelle le fil (6) passe par-dessus la roue de guidage (7) entre la bobine d'alimentation en fil (1) et la cale de connexion de telle sorte que la consommation de fil durant un cycle de connexion provoque la déflexion du levier (8) depuis sa première position à sa deuxième position, et
dans laquelle la position du deuxième capteur (B) peut être ajustée pour permettre l'alimentation en fil en différentes quantités.

2. Dispositif selon la revendication 1, dans lequel le deuxième capteur qui arrête le moteur (3) comprend un interrupteur à minuterie.

3. Dispositif selon la revendication 1 ou 2, dans lequel le premier capteur (A) et/ou le deuxième capteur (B) est une barrière lumineuse.
